(19) Europäisches Patentamt
European Patent Office
Office européen des brevets

(11) **EP 2 609 435 B1**

(12) **EUROPÄISCHE PATENTSCHRIFT**

(45) Veröffentlichungstag und Bekanntmachung des Hinweises auf die Patenterteilung:
**20.04.2016 Patentblatt 2016/16**

(21) Anmeldenummer: **11746504.7**

(22) Anmeldetag: **26.07.2011**

(51) Int Cl.:
*G01R 27/28* *(2006.01)*    *G01R 35/00* *(2006.01)*

(86) Internationale Anmeldenummer:
**PCT/EP2011/062776**

(87) Internationale Veröffentlichungsnummer:
**WO 2012/025320 (01.03.2012 Gazette 2012/09)**

(54) **KALIBRIEREINRICHTUNG FÜR EINEN NETZWERKANALYSATOR**

CALIBRATING DEVICE FOR A NETWORK ANALYSER

SYSTÈME D'ÉTALONNAGE D'UN ANALYSEUR DE RÉSEAU

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.08.2010 DE 102010035191**

(43) Veröffentlichungstag der Anmeldung:
**03.07.2013 Patentblatt 2013/27**

(73) Patentinhaber: **Rohde & Schwarz GmbH & Co. KG 81671 München (DE)**

(72) Erfinder:
• **HASSLER, Martin 81547 München (DE)**
• **RICHTER, Wolfgang 85540 Haar (DE)**

(74) Vertreter: **Körfer, Thomas Mitscherlich PartmbB Patent- und Rechtsanwälte Sonnenstrasse 33 80331 München (DE)**

(56) Entgegenhaltungen:
WO-A1-2004/113936    DE-A1-102005 018 073
US-A1- 2004 150 411    US-A1- 2008 197 858
US-B1- 6 965 241

EP 2 609 435 B1

## Beschreibung

Die Erfindung betrifft eine elektronische Kalibriereinrichtung für einen Netzwerkanalysator mit mehreren Toren.

Hochgenaue Messgeräte wie Netzwerkanalysatoren müssen in regelmäßigen Abständen kalibriert werden, damit sichergestellt ist, dass die geforderte Messgenauigkeit weiterhin erreicht wird. Eine solche Kalibrierung kann bei sehr breitbandigen Netzwerkanalysatoren, die z. B. einen Frequenzbereich von einigen kHz bis hin zu ungefähr 70 GHz abdecken, z.T. mehrmals am Tag erforderlich sein.

Allerdings sind die derzeitigen elektronischen Kalibriereinrichtungen derart aufgebaut, dass sie maximal zwei Tore des Netzwerkanalysators für den oben genannten Frequenzbereich abdecken können. Für eine vollständige Kalibrierung eines z. B. 4-Tor Netzwerkanalysators muss die Kalibriereinrichtung nacheinander mit unterschiedlichen Toren verbunden werden. Dieses Verbinden ist zeitaufwendig und Fehler, z. B. durch eine nicht fest angezogene Schraubverbindung und dadurch auftretende ungewollte Reflexionsstellen, führen dazu, dass der gesamte Kalibriervorgang wiederholt werden muss.

Aus der US 6,914,436 B2 ist eine elektronische Kalibriereinrichtung für einen Netzwerkanalysator mit zwei Toren dargestellt. Die Kalibriereinrichtung unterstützt die bekannten Kalibrierstandards Offen (engl. open), Kurzschluss (engl. short), Angepasst (engl. match) und Durchgehend (engl. through). Die Kalibriereinrichtung besteht dabei aus einzelnen SPDTs (engl. Single Pole Double Throw; dt. Einzel-Pol doppelt umlegend), die miteinander verbunden sind und zusammen auf einem Chip integriert sind.

Nachteilig an der US 6,914,436 B2 ist, dass eine Kalibriereinrichtung für einen 2-Tor Netzwerkanalysator vier SPDTs benötigt, wobei jeder SPDT sechs Transistoren aufweist und damit insgesamt 24 Transistoren notwendig sind. Außerdem sind separate Abschlusswiderstände enthalten, so dass der Aufbau der Kalibriereinrichtung bereits für zwei Tore komplex ist und für weitere Messtore in seiner Komplexität zunimmt, bzw. die zu erreichende obere Grenzfrequenz stark abnimmt.

US 2008/0197 858 A offenbart eine kalibriereinrichtung mit 2 Transistorschaltern an jedem Tor.

Es ist daher die Aufgabe der Erfindung, eine Kalibriereinrichtung zu schaffen, deren Aufbau eine minimale Anzahl von Bauelementen umfasst, um dadurch die benötigte Chipfläche zu minimieren und die obere Grenzfrequenz zu erhöhen.

Die Aufgabe wird bezüglich der Kalibriereinrichtung durch die Merkmale des Anspruchs 1 gelöst. In den Unteransprüchen sind vorteilhafte Weiterbildungen der erfindungsgemäßen Kalibriereinrichtung enthalten.

Die Kalibriereinrichtung für einen Netzwerkanalysator mit mehreren Toren, weist eine Kalibrierschaltung auf, die über je ein Anschlusstor mit je einem der mehreren Tore des Netzwerkanalysators verbunden ist, wobei an jedem Anschlusstor ein erster Transistor und ein zweiter Transistor in Reihe geschaltet sind und wobei beide Transistoren an ihrer gemeinsamen Verbindung mit dem Anschlusstor verbunden sind. Der erste und/oder der zweite Transistor ist dabei als einstellbare Last betrieben.

Der erste und/oder zweite Transistor ist als einstellbare Last betreibbar. Dadurch kann auf einen separaten Abschlusswiderstand und weitere Transistoren verzichtet werden, wodurch die Kalibrierschaltung weiter verkleinert werden kann. Damit ist es möglich, dass die Kalibriereinrichtung für einen Netzwerkanalysator mit mehreren Toren und einer hohen oberen Grenzfrequenz überhaupt erst geeignet ist.

Die einstellbare Last des ersten Transistors ist durch Anlegen einer Gatespannung oder eines Basisstroms einstellbar. Dadurch kann auf sehr einfache Weise der Arbeitspunkt des Transistors angepasst werden. Dies geschieht sehr schnell, so dass der Kalibriervorgang sehr schnell abgeschlossen werden kann.

Ein zusätzlicher Vorteil besteht, wenn beim Einstellen der Gatespannung oder des Basisstroms temperaturabhängige Eigenschaften des ersten Transistors kompensiert sind. Dadurch kann die einzustellende Last auch bei unterschiedlichen Umgebungstemperaturen genau eingestellt werden, wodurch die Genauigkeit des Kalibriervorgangs weiter erhöht wird.

Außerdem stellt sich ein Vorteil ein, wenn die Kalibriereinrichtung eine thermostatische Regelung aufweist, so dass die Kalibrierschaltung auf eine konstante Temperatur beheizbar ist. Dadurch können die temperaturabhängigen Eigenschaften der Transistoren noch besser berücksichtigt und kompensiert werden, weil die Kalibrierschaltung immer dieselbe Temperatur aufweist.

Für jedes der mehreren Tore des Netzwerkanalysators sind genau ein erster und genau ein zweiter Transistor innerhalb der Kalibrierschaltung vorhanden. Dadurch kann die gesamte Anzahl an benötigten Bauelementen weiter minimiert werden, so dass z. B. ein 8-Tor Netzwerkanalysator eine Kalibriereinrichtung erfordert, deren Kalibrierschaltung gerade 16 Transistoren aufweisen muss, wodurch die Chipgröße der Kalibrierschaltung weiter reduziert und die obere Grenzfrequenz erhöht werden kann.

Schlussendlich besteht ein Vorteil, wenn der erste und der zweite Transistor ein Transistorpaar bilden und dadurch mehrere solcher Transistorpaare über einen nicht mit der gemeinsamen Verbindung verbundenen Anschluss des zweiten Transistors miteinander verbindbar sind. Dies erlaubt das zyklische Erweitern der Kalibrierschaltung, um dadurch Netzwerkanalysatoren mit jedweder Anzahl an Messtoren kalibrieren zu können, ohne dass die Kalibriereinrichtung nacheinander mit verschiedenen Messtoren des Netzwerkanalysators verbunden werden muss. Dadurch wird einerseits die Geschwindigkeit des Kalibriervorgangs erhöht und andererseits die Wahrscheinlichkeit des Auftretens von Fehlern verringert.

Verschiedene Ausführungsbeispiele der Erfindung werden nachfolgend unter Bezugnahme auf die Zeichnung beispielhaft beschrieben. Gleiche Gegenstände weisen dieselben Bezugszeichen auf. Die entsprechenden Figuren der Zeichnung zeigen im Einzelnen:

Fig. 1    ein Blockschaltbild eines Ausführungsbeispiels einer erfindungsgemäßen Kalibriereinrichtung mit Kalibrierschaltung;

Fig. 2    ein Blockschaltbild eines Ausführungsbeispiels der erfindungsgemäßen Kalibrierschaltung für zwei Tore des zu kalibrierenden Netzwerkanalysators;

Fig. 3    ein weiteres Blockschaltbild eines Ausführungsbeispiels der erfindungsgemäßen Kalibrierschaltung für vier Tore des zu kalibrierenden Netzwerkanalysators;

Fig. 4    ein weiteres Blockschaltbild eines Ausführungsbeispiels der erfindungsgemäßen Kalibrierschaltung für bis zu acht Tore des zu kalibrierenden Netzwerkanalysators;

Fig. 5    ein weiteres Blockschaltbild eines Ausführungsbeispiels der erfindungsgemäßen Kalibrierschaltung für mehrere Tore des zu kalibrierenden Netzwerkanalysators;

Fig. 6A    ein Ausführungsbeispiel eines Amplitudengangs der erfindungsgemäßen Kalibrierschaltung über die Frequenz aufgetragen für eine Offen-Messung;

Fig. 6B    ein Ausführungsbeispiel eines Amplitudengangs der erfindungsgemäßen Kalibrierschaltung über die Frequenz aufgetragen für eine KurzschlussMessung;

Fig. 6C    ein Ausführungsbeispiel eines Amplitudengangs der erfindungsgemäßen Kalibrierschaltung über die Frequenz aufgetragen für eine Angepasst-Messung;

Fig. 6D    ein Ausführungsbeispiel eines Amplitudengangs der erfindungsgemäßen Kalibrierschaltung über die Frequenz aufgetragen für eine Durchgehend-Messung;

Fig. 7A    ein Ausführungsbeispiel eines Verhältnisses zwischen einer Offen-Messung und einer Kurzschluss-Messung der erfindungsgemäßen Kalibrierschaltung über die Frequenz aufgetragen;

Fig. 7B    ein Ausführungsbeispiel eines Verhältnisses zwischen einer Offen-Messung und einer Angepasst-Messung der erfindungsgemäßen Kalibrierschaltung über die Frequenz aufgetragen; und

Fig. 7C    ein Ausführungsbeispiel eines Verhältnisses zwischen einer Kurzschluss-Messung und einer Offen-Messung der erfindungsgemäßen Kalibrierschaltung über die Frequenz aufgetragen.

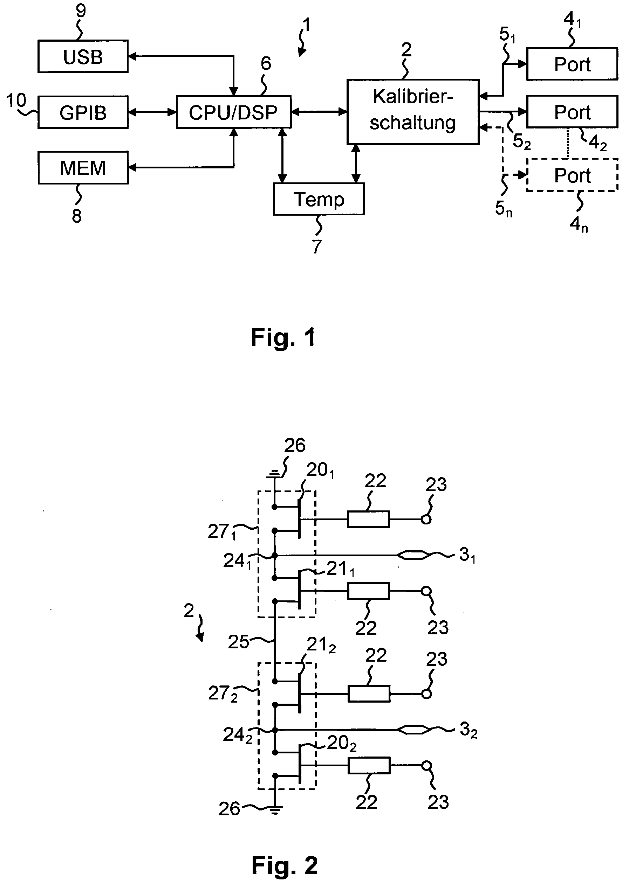

Fig. 1 zeigt ein Blockschaltbild eines Ausführungsbeispiels einer Kalibriereinrichtung 1 mit der erfindungsgemäßen Kalibrierschaltung 2. Die erfindungsgemäße Kalibrierschaltung 2 ist über mehrere in Fig. 1 nicht dargestellte Anschlusstore $3_1$, $3_2$ bis $3_n$ mit mehreren äußeren Toren $4_1$, $4_2$ bis $4_n$ der Kalibriereinrichtung 1 verbunden. Diese Verbindung $5_1$, $5_2$ bis $5_n$ erfolgt bevorzugt durch einen Koaxial-Koplanar-Mikrowellen-Übergang, wie er z. B. in der Patentanmeldung DE 10 2007 013 968 A1 beschrieben ist. Ein solcher Koaxial-Koplanar-Mikrowellen-Übergang ist sehr breitbandig und er ist sowohl bezüglich Reflexion als auch Dämpfung optimal und erlaubt gleichzeitig eine gute mechanische und thermische Entkopplung zwischen dem Koplanar-Leitungssystem und der Koaxialleitung. Die äußeren Tore $4_1$, $4_2$ bis $4_n$ der Kalibriereinrichtung 1 werden dabei bevorzugt über eine Koaxialleitung mit den mehreren Toren des Netzwerkanalysators verbunden.

Die erfindungsgemäße Kalibriereinrichtung 1 weist weiterhin eine zentrale Verarbeitungseinheit 6 (engl. central processing unit) und/oder einen digitalen Signalprozessor 6 auf. Diese zentrale Verarbeitungseinheit 6 ist über eine Datenverbindung mit der Kalibrierschaltung 2 verbunden. Die zentrale Verarbeitungseinheit 6 steuert die Kalibrierschaltung 2 über diese Datenverbindung derart, dass die Kalibrierschaltung die Anschlusstore $3_1$, $3_2$ bis $3_n$ untereinander oder mit verschiedenen Lasten verbindet. Eine genaue Erläuterung hierfür wird in der Beschreibung später gegeben.

Außerdem weist die Kalibriereinrichtung 1 bevorzugt eine thermostatische Regelung 7 auf, wodurch die Kalibrierschaltung 2 auf eine konstante Temperatur beheizbar ist. Die thermostatische Regelung 7 ist einerseits über eine erste Datenverbindung mit der zentralen Verarbeitungseinheit 6 und andererseits über eine zweite Datenverbindung mit der Kalibrierschaltung 2 verbunden. Über die zweite Datenverbindung werden dabei bevorzugt Temperaturwerte der Kalibrierschaltung 2 erfasst. Diese werden über die erste Datenverbindung an die zentrale Verarbeitungseinheit 6 übertragen. Die zentrale Verarbeitungseinheit 6 gibt den Sollwert für eine Temperatur vor, auf den die thermostatische Regelung 7 die Kalibrierschaltung 2 mit den nicht dargestellten Heizelementen aufheizen soll. Dabei wird der Sollwert bevorzugt derart gewählt, dass er von einer normalen Umgebungstemperatur nicht erreicht wird. Ein Sollwert von 30 bis 50°C, bevorzugt etwa 40 °C, erweist sich dabei als vorteilhaft, weil bei 40 °C der Alterungsprozess der Kalibrierschaltung 2, insbesondere der Transistoren innerhalb der Kalibrierschaltung 2, vernachlässigbar ist und dieser Wert über der zu erwartenden Umgebungstemperatur liegt. Die thermostatische Regelung 7 regelt die nicht dargestellten Heizelemente derart, dass der vorgegebene Sollwert möglichst genau erreicht wird.

Weiterhin weist die Kalibriereinrichtung 1 eine Speichereinheit 8 (engl. memory unit) auf. Die Speichereinheit 8 ist über eine Datenverbindung mit der zentralen Verarbeitungseinheit 6 verbunden. Die Speichereinheit 8 enthält Korrekturdaten, die das frequenzabhängige Verhalten der Kalibrierschaltung 2 sowie aller Anschlussverbindungen zwischen der Kalibrierschaltung 2 und den äußeren Toren $4_1$, $4_2$, bis $4_n$ genau beschreiben. Außerdem ist das temperaturabhängige Verhalten der Kalibrierschaltung 2 in der Speichereinheit 8 hinterlegt.

Weiterhin weist die Kalibriereinrichtung 1 eine Schnittstelle, bevorzugt einen USB-Anschluss 9 (engl. universal serial bus; dt. universeller serieller Bus) und/oder einen GPIB-Anschluss (engl. general purpose interface bus; dt. Schnittstellen Bus für allgemeine Verwendung) 10 auf. Über diese Anschlüsse 9, 10 ist die Kalibriereinrichtung 1 mit dem zu kalibrierenden Netzwerkanalysator verbunden. Über diese Datenverbindung teilt der Netzwerkanalysator der Kalibriereinrichtung 1 mit, welcher Kalibrierstandard (z. B. Offen, Kurzschluss, Angepasst, Durchgehend) bei welcher Frequenz und ggf. bei welcher Amplitude gemessen werden soll. Die Kalibriereinrichtung 1 stellt den gewünschten Kalibrierstandard ein und übermittelt dem Netzwerkanalysator die entsprechenden Korrekturdaten. Die Übermittlung der Korrekturdaten zwischen der Kalibriereinrichtung 1 und dem Netzwerkanalysator kann auch zu Beginn der Kalibrierung insgesamt erfolgen.

Fig. 2 zeigt ein Blockschaltbild eines Ausführungsbeispiels der erfindungsgemäßen Kalibrierschaltung 2 für einen Netzwerkanalysators mit zwei zu kalibrierenden Toren. Allerdings ist die erfindungsgemäße Kalibrierschaltung 2, wie im Weiteren noch erläutert wird, auch für n-Tore, mit n > 2 einsetzbar. Der Aufbau der Kalibriereinrichtung 1 mit der erfindungsgemäßen Kalibrierschaltung 2 ist derart, dass für jedes der mehreren zu kalibrierenden Tore des Netzwerkanalysators je ein äußeres Tor $4_1$, $4_2$, bis $4_n$ am Gehäuse der Kalibriereinrichtung 1 vorhanden ist, welches bevorzugt über einen Koaxial-Koplanar-Mikrowellen-Übergang mit je einem Anschlusstor $3_1$, $3_2$ bis $3_n$ der Kalibrierschaltung 2 verbunden ist. Unter mehreren zu kalibrierenden Toren des Netzwerkanalysators sind zumindest zwei Tore bis unendlich viele Tore zu verstehen, wobei es sich bevorzugt um zwei oder vier oder acht Tore handelt. An jedes Anschlusstor $3_1$, $3_2$ bis $3_n$ der Kalibrierschaltung 2 ist ein erster Transistor $20_1$, $20_2$, bis $20_n$ und ein zweiter Transistor $21_1$, $21_2$ bis $21_n$ in Reihe geschaltet, wobei beide Transistoren $20_1$, $20_2$ bis $20_n$ und $21_1$, $21_2$ bis $21_n$ an ihrer gemeinsamen Verbindung $24_1$, $24_2$ bis $24_n$ mit dem Anschlusstor $3_1$, $3_2$ bis $3_n$ verbunden sind.

Ein erster Anschluss des ersten Transistors $20_1$, $20_2$ bis $20_n$ ist dabei mit einer Bezugsmasse 26 verbunden. Ein zweiter Anschluss des ersten Transistors $20_1$, $20_2$ bis $20_n$ ist über die gemeinsame Verbindung $24_1$, $24_2$ bis $24_n$ mit einem ersten Anschluss des zweiten Transistors $21_1$, $21_2$ bis $21_n$ verbunden, so dass von einer Reihenschaltung zwischen dem ersten Transistor $20_1$, $20_2$ bis $20_n$ und dem zweiten Transistor $21_1$, $21_2$ bis $21_n$ gesprochen wird. Ein dritter Anschluss des ersten Transistors $20_1$, $20_2$ bis $20_n$ und des zweiten Transistors $21_1$, $21_2$ bis $21_n$ wird bevorzugt über einen Vorwiderstand 22 am Anschluss 23 mit einer nicht dargestellten Spannungsquelle oder Stromquelle verbunden. Bei den Transistoren $20_1$, $20_2$ bis $20_n$ und $21_1$, $21_2$ bis $21_n$ handelt es sich bevorzugt um Feldeffekttransistoren und innerhalb dieser Gruppe insbesondere um pHEMT-Transistoren (engl. pseudomorphic high electron mobility transistor; dt. pseudomorphischer Transistor mit hoher Elektronenbeweglichkeit). In diesem Fall handelt es sich bei dem dritten Anschluss des ersten Transistors $20_1$, $20_2$ bis $20_n$ und des zweiten Transistors $21_1$, $21_2$ bis 21 um das Gate (dt. Tor) und die dem Anschluss 23 zugeführte Spannung wird auch als Steuerspannung bzw. Gatespannung bezeichnet. Weiterhin handelt es sich bei dem ersten Anschluss der ersten Transistoren $20_1$, $20_2$ bis $20_n$ und der zweiten Transistoren $21_1$, $21_2$ bis $21_n$ um einen Source-Anschluss (dt. Quelle) und bei dem zweiten Anschluss der ersten Transistoren $20_1$, $20_2$ bis $20_n$ und der zweiten Transistoren $21_1$, $21_2$ bis $21_n$ um einen Drain-Anschluss (dt. Senke).

Jeweils der erste Transistor $20_1$, $20_2$ bis $20_n$ und der dazu korrespondierende zweite Transistor $21_1$, $21_2$ bis $21_n$ bilden ein Transistorpaar $27_1$, $27_2$ bis $27_n$, wobei mehrere solcher Transistorpaare $27_1$, $27_2$ bis $27_n$ über einen nicht mit der gemeinsamen Verbindung $24_1$, $24_2$ bis $24_n$ verbundenen Anschluss des zweiten Transistors $21_1$, $21_2$ bis $21_n$ miteinander verbindbar sind. Diese Verbindung der Transistorpaare $27_1$, $27_2$ bis $27_n$ untereinander erfolgt dabei über die Verbindungsleitung 25, an die alle Transistorpaare $27_1$, $27_2$ bis $27_n$ parallel angeschlossen sind. Bei dem nicht mit der gemeinsamen Verbindung $24_1$, $24_2$ bis $24_n$ verbundenen Anschluss des zweiten Transistors $21_1$, $21_2$ bis $21_n$ handelt es sich um den zweiten Anschluss des zweiten Transistors $21_1$, $21_2$ bis $21_n$, bzw. um z. B. den Drain-Anschluss des zweiten Transistors $21_1$, $21_2$ bis $21_n$ bei Verwendung von Feldeffekttransistoren.

Dadurch, dass für jedes der mehreren Tore des Netzwerkanalysators genau ein erster Transistor $20_1$, $20_2$ bis $20_n$ und ein zweiter Transistor $21_1$, $21_2$ bis $21_n$ innerhalb der Kalibrierschaltung 2 vorhanden sind, können sehr viele Transistorpaare $27_1$, $27_2$ bis $27_n$ parallel miteinander verbunden werden, bis die parasitäre Kapazität schließlich derart zunimmt, dass die obere Grenzfrequenz der Kalibriereinrichtung 1 nicht mehr für den zu kalibrierenden Netzwerkanalysator ausreicht.

Der erste Transistor $20_1$, $20_2$ bis $20_n$ und der zweite Transistor $21_1$, $21_2$ bis $21_n$ werden als einstellbare Last betrieben. In den gezeichneten erfindungsgemäßen Ausführungsbeispielen ist allerdings nur der erste Transistor $20_1$, $20_2$ bis $20_n$ als einstellbare Last betreibbar. Die einstellbare Last des ersten Transistors $20_1$, $20_2$ bis $20_n$ ist dabei durch Anlegen einer Steuerspannung bzw. Gatespannung, oder eines Steuerstroms bzw. Basisstroms, bei Verwendung von bipolaren Transistoren, an diesem einstellbar. Dabei wird je nach eingestellter Steuerspannung bzw. Gatespannung der Arbeitspunkt des Transistors eingestellt. Je nach eingestellter Gatespannung ändert sich der ohmsche Widerstand des ersten Transistors $20_1$, $20_2$ bis $20_n$, so dass als einstellbare Last der leitende und der sperrende Zustand des ersten Transistors $20_1$, $20_2$ bis $20_n$ als auch sämtliche resistive Zwischenzustände einstellbar sind. Die resistiven Zwischenzustände liegen dabei zwischen dem niederohmigen leitenden Zustand und dem hochohmigen sperrenden Zustand. Bei einem typischerweise ausgewählten resistiven Zwischenzustand beträgt der Widerstandswert des ersten Transistors $20_1$, $20_2$ bis $20_n$ z. B. 50 Ohm.

Der erste Transistor $20_1$, $20_2$ bis $20_n$ wird dabei nicht in der Sättigung betrieben, sondern bei Verwendung von Feldeffekttransistoren im Triodenbereich.

Allerdings sollte der erste Transistor $20_1$, $20_2$ bis $20_n$ nicht in der Sättigung betrieben werden. Die eingestellte Last bzw. die resistiven Zwischenzustände sind neben der Steuerspannung bzw. Gatespannung hauptsächlich noch abhängig von z. B. der Drain-Source-Spannung, der Temperatur des Transistors und der Frequenz des angelegten Signals. Dieses stark von äußeren Faktoren abhängige Verhalten des ersten Transistors $20_1$, $20_2$ bis $20_n$ ist in der Speichereinheit 8 in Form von Kalibrierdaten hinterlegt. Um den Einfluss der Temperatur möglichst niedrig zu halten, wird die Kalibrierschaltung 2 über an die thermostatische Regelung 7 angeschlossene Heizelemente auf eine konstante Temperatur beheizt. Dadurch kann die notwendige Anzahl an Kalibrierdaten gesenkt werden.

Der erste Transistor $20_1$, $20_2$ bis $20_n$, der mit seinem ersten Anschluss mit der Bezugsmasse 26 verbunden ist, wird bevorzugt dazu verwendet, um die Kalibrierstandards Offen, Kurzschluss und Angepasst über die gemeinsame Verbindung $24_1$, $24_2$ und $24_3$ auf die Anschlusstore $3_1$, $3_2$ bis $3_n$ und damit auf die mehreren Tore des Netzwerkanalysators zu schalten. Bei dem Kalibrierstandard Angepasst wird die Steuerspannung bzw. Gatespannung oder der Steuerstroms bzw. Basisstrom des ersten Transistors $20_1$, $20_2$ bis $20_n$ derart eingestellt, dass der resistive Zwischenzustand, bzw. die eingestellte Last, weitestgehend einer Systemimpedanz des zu kalibrierenden Netzwerkanalysators entspricht. Bei der Systemimpedanz handelt es sich gewöhnlich um 50 Ohm, wobei auch andere Werte durch Ändern der Steuerspannung bzw. Gatespannung, oder des Steuerstroms bzw. Basisstrom einstellbar sind. Die Kalibrierstandards Offen und Kurzschluss können dadurch realisiert werden, dass sich der erste Transistor $20_1$, $20_2$ bis $20_n$ im sperrenden oder im voll leitenden Zustand befindet.

Die Zustandstabelle (1) enthält alle erforderlichen Zustände der Transistoren $20_1$, $20_2$ und $21_1$, $21_2$ aus Fig. 2.

Tabelle 1

| Zustand | $T20_1$ | $T21_1$ | $T20_2$ | $T21_2$ |
|---|---|---|---|---|
| Offen $3_1$ | $V_{aus}$ | $V_{aus}$ | $V_{an}$ | $V_{an}$ |
| Kurzschluss $3_1$ | $V_{an}$ | $V_{aus}$ | $V_{an}$ | $V_{an}$ |
| Angepasst $3_1$ | $V_{50}$ | $V_{aus}$ | $V_{an}$ | $V_{an}$ |
| Offen $3_2$ | $V_{an}$ | $V_{an}$ | $V_{aus}$ | $V_{aus}$ |
| Kurzschluss $3_2$ | $V_{an}$ | $V_{an}$ | $V_{an}$ | $V_{aus}$ |
| Angepasst $3_2$ | $V_{an}$ | $V_{an}$ | $V_{50}$ | $V_{aus}$ |
| Durchgehend $3_1 \leftrightarrow 3_2$ | $V_{aus}$ | $V_{an}$ | $V_{aus}$ | $V_{an}$ |

Sobald für das Anschlusstor $3_1$ z. B. der Kalibrierstandard Offen geschaltet werden soll, werden die mit dem Anschlusstor $3_1$ verbundenen Transistoren $20_1$, $21_1$ in den sperrenden Zustand geschaltet. Um die Isolation zu erhöhen, werden die anderen Transistoren $20_2$ und $21_2$ in den leitenden Zustand geschaltet. Selbiges gilt für die Kalibrierstandards Kurzschluss und Angepasst sowohl für das Anschlusstor $3_1$ als auch für das Anschlusstor $3_2$. Sobald der Kalibrierstandard Durchgehend geschaltet werden soll, werden die beiden ersten Transistoren $20_1$, $20_2$ in den sperrenden Zustand geschaltet und die beiden zweiten Transistoren $20_1$, $20_2$ in den leitenden Zustand geschaltet.

Es ist auch möglich, dass die Kalibrierstandards Offen, Kurzschluss und Angepasst für alle der mehreren Tore des Netzwerkanalysators parallel zueinander einstellbar und messbar sind. Die hierfür notwendige Zustandstabelle (2) zeigt die einzustellenden Zustände der Transistoren $20_1$, $20_2$ und $21_1$, $21_2$ aus Fig. 2.:

Tabelle 2

| Zustand | $T20_1$ | $T21_1$ | $T20_2$ | $T21_2$ |
|---|---|---|---|---|
| Offen $3_1$ und $3_2$ | $V_{aus}$ | $V_{aus}$ | $V_{aus}$ | $V_{aus}$ |
| Kurzschluss $3_1$ und $3_2$ | $V_{an}$ | $V_{aus}$ | $V_{an}$ | $V_{aus}$ |
| Angepasst $3_1$ und $3_2$ | $V_{50}$ | $V_{aus}$ | $V_{50}$ | $V_{aus}$ |
| Durchgehend $3_1 \leftrightarrow 3_2$ | $V_{aus}$ | $V_{an}$ | $V_{aus}$ | $V_{an}$ |

Dadurch ist es möglich, dass die Zeitdauer für den Kalibriervorgang weiter gesenkt werden kann. Ob dies über den gesamten Frequenzbereich bis hin zu z. B. 70 GHz möglich ist, hängt von den sich ausbildenden parasitären Kapazitäten und der Isolationsfähigkeit der einzelnen Transistoren im sperrenden Zustand ab. Allerdings kann dieses parallele Einstellen der drei Kalibrierstandards Offen, Kurzschluss und Angepasst bei Bedarf auch nur für einen bestimmten Frequenzbereich bis zu z. B. 30 GHz durchgeführt werden, so dass für Frequenzen oberhalb z. B. 30 GHz sämtliche Kalibrierstandards sequentiell eingestellt und gemessen werden.

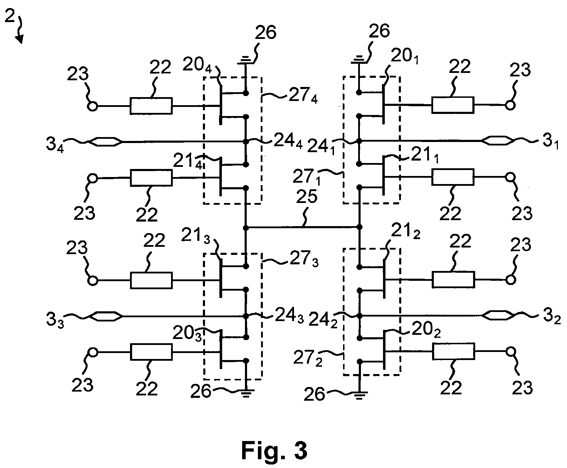

Fig. 3 zeigt ein weiteres Blockschaltbild eines Ausführungsbeispiels der erfindungsgemäßen Kalibrierschaltung 2 für bis zu vier Tore des zu kalibrierenden Netzwerkanalysators. Dargestellt sind jeweils vier Transistorpaare $27_1$, $27_2$, $27_3$ und $27_4$, die über die Verbindungsleitung 25 miteinander verbunden sind. Wie bei der Schaltungsanordnung aus Fig. 2 sind es auch bei Fig. 3 bevorzugt die zweiten Anschlüsse der zweiten Transistoren $21_1$, $21_2$, $21_3$ und $21_4$, die miteinander über die Verbindungsleitung 25 verbunden sind. Die Funktionsweise der einzelnen Transistorpaare $27_1$, $27_2$, $27_3$ und $27_4$ aus Fig. 3 entspricht der Funktionsweise der Transistorpaare $27_1$ und $27_2$ aus Fig. 2, so dass auf den entsprechenden Teil der Beschreibung zu Fig. 2 verwiesen wird. Auch in Fig. 3 können bevorzugt diejenigen Transistoren $20_1$, $20_2$, $20_3$ und $20_4$ als variable Last betrieben werden, deren erster Anschluss direkt mit der Bezugsmasse 26 verbunden ist. Die dafür notwendige Gatespannung muss sehr genau, z. B. auf 100 μV genau, einstellbar sein.

Die Zustandstabelle (3) enthält alle erforderlichen Zustände der Transistoren $20_1$, $20_2$ und $21_1$, $21_2$ aus Fig. 3.

Tabelle 3

| Zustand | $T20_1$ | $T21_1$ | $T20_2$ | $T21_2$ | $T20_3$ | $T21_3$ | $T20_4$ | $T21_4$ |
|---|---|---|---|---|---|---|---|---|
| Offen $3_1$ | $V_{off}$ | $V_{off}$ | $V_{on}$ | $V_{on}$ | $V_{on}$ | $V_{on}$ | $V_{on}$ | $V_{on}$ |
| Kurzschluss $3_1$ | $V_{on}$ | $V_{off}$ | $V_{on}$ | $V_{on}$ | $V_{on}$ | $V_{on}$ | $V_{on}$ | $V_{on}$ |
| Angepasst $3_1$ | $V_{50}$ | $V_{off}$ | $V_{on}$ | $V_{on}$ | $V_{on}$ | $V_{on}$ | $V_{on}$ | $V_{on}$ |
| Offen $3_2$ | $V_{on}$ | $V_{on}$ | $V_{off}$ | $V_{off}$ | $V_{on}$ | $V_{on}$ | $V_{on}$ | $V_{on}$ |
| Kurzschluss $3_2$ | $V_{on}$ | $V_{on}$ | $V_{on}$ | $V_{off}$ | $V_{on}$ | $V_{on}$ | $V_{on}$ | $V_{on}$ |
| Angepasst $3_2$ | $V_{on}$ | $V_{on}$ | $V_{50}$ | $V_{off}$ | $V_{on}$ | $V_{on}$ | $V_{on}$ | $V_{on}$ |
| Offen $3_3$ | $V_{on}$ | $V_{on}$ | $V_{on}$ | $V_{on}$ | $V_{off}$ | $V_{off}$ | $V_{on}$ | $V_{on}$ |
| Kurzschluss $3_3$ | $V_{on}$ | $V_{on}$ | $V_{on}$ | $V_{on}$ | $V_{on}$ | $V_{off}$ | $V_{on}$ | $V_{on}$ |
| Angepasst $3_3$ | $V_{on}$ | $V_{on}$ | $V_{on}$ | $V_{on}$ | $V_{50}$ | $V_{off}$ | $V_{on}$ | $V_{on}$ |
| Offen $3_4$ | $V_{on}$ | $V_{on}$ | $V_{on}$ | $V_{on}$ | $V_{on}$ | $V_{on}$ | $V_{off}$ | $V_{off}$ |
| Kurzschluss $3_4$ | $V_{on}$ | $V_{on}$ | $V_{on}$ | $V_{on}$ | $V_{on}$ | $V_{on}$ | $V_{on}$ | $V_{off}$ |
| Angepasst $3_4$ | $V_{on}$ | $V_{on}$ | $V_{on}$ | $V_{on}$ | $V_{on}$ | $V_{on}$ | $V_{50}$ | $V_{off}$ |
| Durchgehend $3_1 \leftrightarrow 3_2$ | $V_{off}$ | $V_{on}$ | $V_{off}$ | $V_{on}$ | $V_{on}$ | $V_{off}$ | $V_{on}$ | $V_{off}$ |
| Durchgehend $3_1 \leftrightarrow 3_3$ | $V_{off}$ | $V_{on}$ | $V_{on}$ | $V_{off}$ | $V_{off}$ | $V_{on}$ | $V_{on}$ | $V_{off}$ |
| Durchgehend $3_1 \leftrightarrow 3_4$ | $V_{off}$ | $V_{on}$ | $V_{on}$ | $V_{off}$ | $V_{on}$ | $v_{off}$ | $V_{off}$ | $V_{on}$ |
| Durchgehend $3_2 \leftrightarrow 3_3$ | $V_{on}$ | $V_{off}$ | $V_{off}$ | $V_{on}$ | $V_{off}$ | $V_{on}$ | $V_{on}$ | $V_{off}$ |
| Durchgehend $3_2 \leftrightarrow 3_4$ | $V_{on}$ | $V_{off}$ | $V_{off}$ | $V_{on}$ | $V_{on}$ | $v_{off}$ | $V_{off}$ | $V_{on}$ |

(fortgesetzt)

| Zustand | $T20_1$ | $T21_1$ | $T20_2$ | $T21_2$ | $T20_3$ | $T21_3$ | $T20_4$ | $T21_4$ |
|---|---|---|---|---|---|---|---|---|
| Durchgehend $3_3 \leftrightarrow 3_4$ | $V_{on}$ | $V_{off}$ | $V_{on}$ | $V_{off}$ | $V_{off}$ | $V_{on}$ | $V_{off}$ | $V_{on}$ |

Sobald für das Anschlusstor $3_1$ z. B. der Kalibrierstandard Kurzschluss geschaltet werden soll, wird der mit dem Anschlusstor $3_1$ verbundene erste Transistor $20_1$ in den leitenden Zustand geschaltet und der zweite Transistor $21_1$ in den sperrenden Zustand geschaltet. Um die Isolation zu erhöhen, werden die anderen Transistoren $20_2$, $21_2$, $20_3$, $21_3$, $20_4$ und $21_4$ in den leitenden Zustand geschaltet. Selbiges gilt für die Kalibrierstandards Offen und Angepasst sowohl für das Anschlusstor $3_1$, als auch für die Anschlusstore $3_2$, $3_3$ und $3_4$. Sobald der Kalibrierstandard Durchgehend geschaltet wird, werden die dafür notwendigen zwei zweiten Transistoren $21_1$, $21_2$, $21_3$ und $21_4$ in den leitenden Zustand und die weiteren zwei zweiten Transistoren $21_1$, $21_2$, $21_3$ und $21_4$ in den sperrenden Zustand geschalten. Die ersten Transistoren $20_1$, $20_2$, $20_3$ und $20_4$ weisen jeweils den konträren Schaltzustand auf, wie die zweiten Transistoren $21_1$, $21_2$, $21_3$ und $21_4$ innerhalb der Transistorpaare $27_1$, $27_2$, $27_3$ und $27_4$.

Es ist auch möglich, dass die drei Kalibrierstandards Offen, Kurzschluss und Angepasst für alle der mehreren Tore des Netzwerkanalysators parallel einstellbar und messbar sind. Dadurch kann gerade bei einer großen Anzahl an zu kalibrierenden Toren die Zeitdauer des Kalibriervorgangs signifikant verkürzt werden.

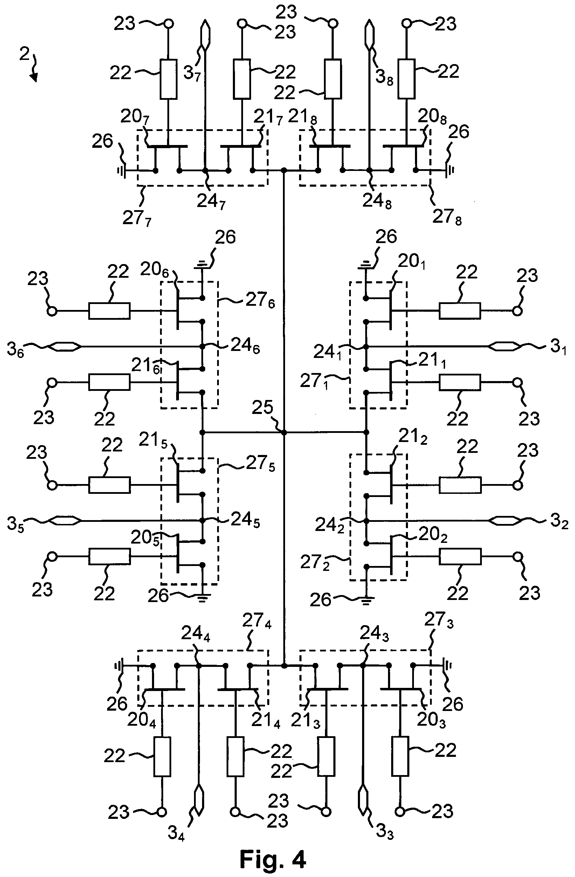

Fig. 4 zeigt ein weiteres Blockschaltbild eines Ausführungsbeispiels der erfindungsgemäßen Kalibrierschaltung 2 für bis zu acht Tore des zu kalibrierenden Netzwerkanalysators. Dargestellt sind jeweils acht Transistorpaare $27_1$, $27_2$, $27_3$, $27_4$, $27_5$, $27_6$, $27_7$ und $27_8$, die über die Verbindungsleitung 25 miteinander verbunden sind. Wie bei der Schaltungsanordnung aus Fig. 2 sind es auch bei Fig. 4 bevorzugt die zweiten Anschlüsse der zweiten Transistoren $21_1$, $21_2$, $21_3$, $21_4$, $21_5$, $21_6$, $21_7$ und $21_8$, die miteinander über die Verbindungsleitung 25 verbunden sind. Die Funktionsweise der einzelnen Transistorpaare $27_1$, $27_2$, $27_3$, $27_4$, $27_5$, $27_6$, $27_7$ und $27_8$ aus Fig. 4 entspricht der Funktionsweise der Transistorpaare $27_1$ und $27_2$ aus Fig. 2, so dass auf den entsprechenden Teil Beschreibung zu Fig. 2 verwiesen wird. Auch in Fig. 4 können bevorzugt diejenigen Transistoren $20_1$, $20_2$, $20_3$, $20_4$, $20_5$, $20_6$, $20_7$ und $20_8$ als variable Last betrieben werden, deren erster Anschluss direkt mit der Bezugsmasse 26 verbunden ist. Die dafür notwendige Gatespannung muss sehr genau, z. B. auf 100 $\mu$V genau, einstellbar sein.

Eine Zustandstabelle, die alle erforderlichen Zustände der Transistoren $20_1$ bis $20_8$ und $21_1$ bis $21_8$ enthält, ist entsprechend den Tabellen (1) und (3) aufgebaut. Dadurch, dass für jedes Anschlusstor $3_1$, $3_2$, $3_3$, $3_4$, $3_5$, $3_6$, $3_7$ und $3_8$ der in Fig. 4 dargestellten Kalibrierschaltung 2 genau ein erster Transistor $20_1$ bis $20_8$ und ein zweiter Transistor $21_1$ bis $21_8$ vorhanden sind, kann die Kalibrierschaltung 2 sehr kompakt aufgebaut werden und die benötigten Verbindungsleitungen können kurz gehalten werden, so dass sehr hohe obere Grenzfrequenzen erreicht werden können.

Es ist auch möglich, dass die drei Kalibrierstandards Offen, Kurzschluss und Angepasst für alle der mehreren Tore des Netzwerkanalysators einstellbar und messbar sind. Dadurch kann gerade bei einer großen Anzahl an zu kalibrierenden Toren die Zeitdauer des Kalibriervorgangs signifikant verkürzt werden.

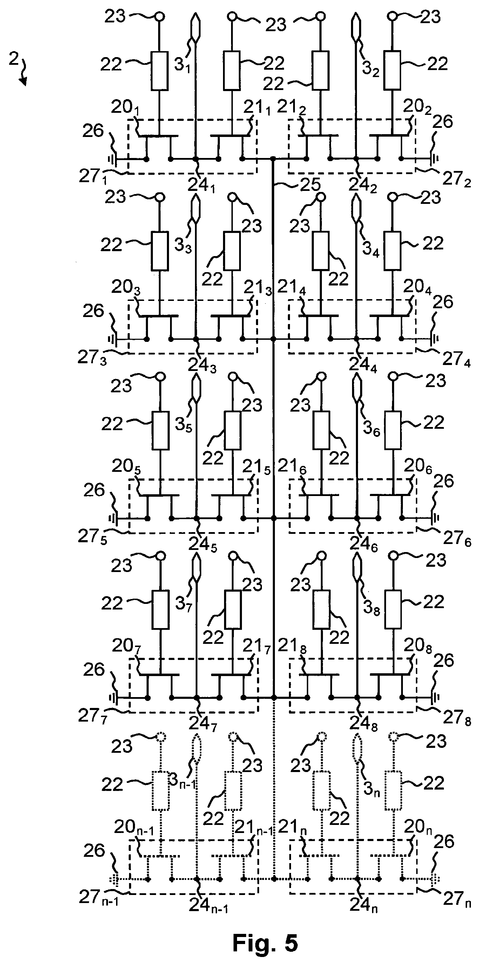

Fig. 5 zeigt ein weiteres Blockschaltbild eines Ausführungsbeispiels der erfindungsgemäßen Kalibrierschaltung 2 für mehrere Tore des zu kalibrierenden Netzwerkanalysators. Dargestellt sind jeweils acht Transistorpaare $27_1$, $27_2$, $27_3$, $27_4$, $27_5$, $27_6$, $27_7$ und $27_8$, die über die Verbindungsleitung 25 miteinander verbunden sind, wie dies bereits der Schaltungsanordnung aus Fig. 4 zu entnehmen ist. Weiterhin sind zwei weitere Transistorpaare $27_{n-1}$ und $27_n$ gepunktet angedeutet. Diese gepunkteten Transistorpaare $27_{n-1}$ und $27_n$ sollen verdeutlichen, dass die Kalibrierschaltung 2 für eine beliebige Anzahl von Anschlusstoren $3_1$ bis $3_{n-1}$, $3_n$ erweiterbar ist, wobei für n gilt: $n \in \mathbb{N} \cap n > 1$.

Wie bei der Schaltungsanordnung aus Fig. 2 sind es auch bei Fig. 5 bevorzugt die zweiten Anschlüsse der zweiten Transistoren $21_1$ bis $21_{n-1}$ und $21_n$, die miteinander über die Verbindungsleitung 25 verbunden sind. Die Funktionsweise der einzelnen Transistorpaare $27_1$ bis $27_{n-1}$ und $27_n$ aus Fig. 5 entspricht der Funktionsweise der Transistorpaare $27_1$ und $27_2$ aus Fig. 2, so dass auf den entsprechenden Teil der Beschreibung zu Fig. 2 verwiesen wird. Auch in Fig. 5 können bevorzugt diejenigen Transistoren $20_1$ bis $20_{n-1}$, $20_n$ als variable Last betrieben werden, deren erster Anschluss direkt mit der Bezugsmasse 26 verbunden ist. Die dafür notwendige Gatespannung muss sehr genau, z. B. auf 100 $\mu$V genau, einstellbar sein.

Eine Zustandstabelle, die alle erforderlichen Zustände der Transistoren $20_1$ bis $20_{n-1}$, $20_n$, sowie $21_1$ bis $21_{n-1}$, $21_n$ enthält, ist entsprechend den Tabellen (1) und (3) aufgebaut. Dadurch, dass für jedes Anschlusstor $3_1$ bis $3_{n-1}$ und $3_n$ der in Fig. 5 dargestellten Kalibrierschaltung 2 genau ein erster Transistor $20_1$ bis $20_{n-1}$, $20_n$ sowie ein zweiter Transistor $21_1$ bis $21_{n-1}$, $21_n$ vorhanden sind, kann die Kalibrierschaltung 2 sehr kompakt aufgebaut werden und die benötigten Verbindungsleitungen können kurz gehalten werden, so dass sehr hohe obere Grenzfrequenzen erreicht werden können.

Es ist auch möglich, dass die drei Kalibrierstandards Offen, Kurzschluss und Angepasst für alle der mehreren Tore des Netzwerkanalysators einstellbar und messbar sind. Dadurch kann gerade bei einer großen Anzahl an zu kalibrierenden Toren die Zeitdauer des Kalibriervorgangs signifikant verkürzt werden.

Bevorzugt sind außerdem die ersten Transistoren $20_1$, $20_2$ bis $20_n$, die mit ihrem ersten Anschluss mit der Bezugsmasse 26 verbunden sind, derart ausgeführt, dass ihre Gatebreite deutlich größer ist, als die Gatebreite der zweiten Transistoren $21_1$, $21_2$ bis $21_n$. Dadurch ist gewährleistet, dass diese einen sehr niederohmigen Kontakt zwischen der Bezugsmasse 26 und der gemeinsamen Verbindung $27_1$, $27_2$ bis $27_n$ mit den Anschlusstoren $3_1$, $3_2$ bis $3_n$ herstellen. Ein derart niederohmiger Kontakt ist für die Kurzschlussmessung von Bedeutung. Für den Fall, dass die ersten Transistoren $20_1$, $20_2$ bis $20_n$ und die zweiten Transistoren $21_1$, $21_2$ bis $21_n$ in einem GaAs/InGaAs/AlGaAs-pHEMT-Halbleiterprozess hergestellt werden, werden sehr gute Ergebnisse für eine Gatelänge von 250 nm erzielt. Damit der erste Transistor $20_1$, $20_2$ bis $20_n$ einen möglichst niederohmigen Kontakt herstellt, ist eine Gatebreite von z. B. 50 $\mu$m vorteilhaft. Bei einer derartigen Ausgestaltung der ersten Transistoren $20_1$, $20_2$ bis $20_n$ ist eine Gatespannung von z. B. $V_{off}$ = -1,5 V ausreichend, damit die ersten Transistoren in einen sperrenden Zustand übergehen. Bei einer Gatespannung von z. B. $V_{50}$ = -0,58 V weist die ohmsche Last, die die ersten Transistoren $20_1$, $20_2$ bis $20_n$ darstellen, einen Wert von z. B. 50 Ohm auf. Bei einer Gatespannung von z. B. Von = 0 V sind die ersten Transistoren $20_1$, $20_2$ bis $20_n$ dagegen in einem leitenden Zustand.

Nachteilig an dieser großen Gatebreite ist, dass die daraus resultierende Gatefläche proportional in die sich einstellenden parasitären Kapazitäten eingeht. Bedeutende parasitäre Kapazitäten ergeben sich zwischen Gate und Drain und zwischen Gate und Source. Größere parasitäre Kapazitäten führen gleichzeitig zu einer niedrigeren oberen Grenzfrequenz. Aus diesem Grund sind bevorzugt die zweiten Transistoren $21_1$, $21_2$ bis $21_n$ mit einer kleineren Gatebreite ausgeführt. Die Gatebreite der zweiten Transistoren $21_1$, $21_2$ bis $21_n$ beträgt dabei bevorzugt z. B. 25 $\mu$m. Der resistive Widerstand wird dabei zwar höher, allerdings steigt der nutzbare Frequenzbereich der Kalibrierschaltung 2 stark an. Weiterhin erhöht eine kleine Gatebreite die Isolationsfestigkeit der zweiten Transistoren $21_1$, $21_2$ bis $21_n$. Dadurch werden auftretende parasitäre Pfade stärker gedämpft.

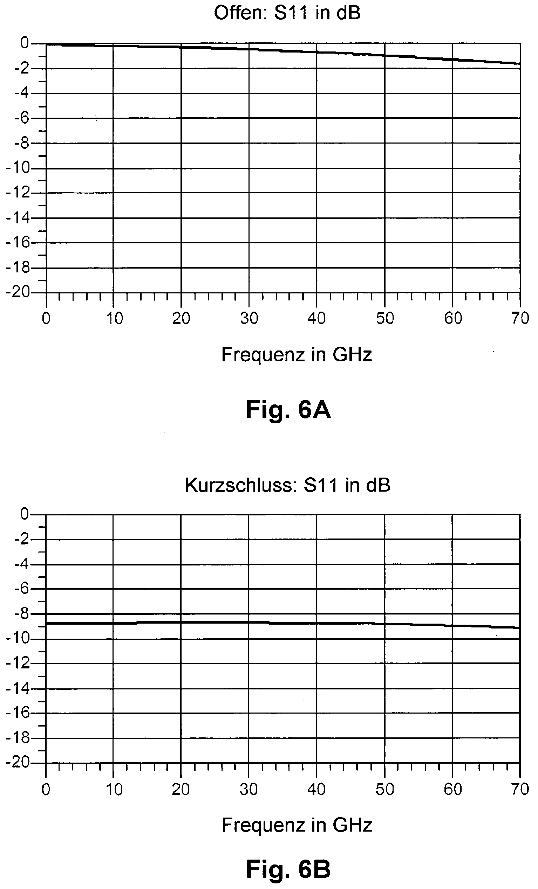

Fig. 6A zeigt ein Ausführungsbeispiel eines Amplitudengangs der erfindungsgemäßen Kalibrierschaltung 2 über die Frequenz aufgetragen für eine Offen-Messung. Innerhalb dieser Messung ist der Eingangsreflexionsfaktor $S_{11}$ z. B. des Anschlusstores $3_1$ für eine Offen-Messung dargestellt. Der Eingangsreflexionsfaktor $S_{11}$ ist dabei für eine Kalibrierschaltung mit vier Anschlusstoren $3_1$, $3_2$, $3_3$ bis $3_4$ bestimmt, wie diese in Fig. 3 dargestellt ist. Dabei sind die Transistoren $20_1$ und $21_1$ im sperrenden Zustand und die Transistoren $20_2$ bis $20_4$ und $21_2$ bis $21_4$ im leitenden Zustand. Zu erkennen ist, dass die rücklaufende Welle selbst bei einer Frequenz von 70 GHz nur marginal gedämpft ist.

Fig. 6B zeigt ein Ausführungsbeispiel eines Amplitudengangs der erfindungsgemäßen Kalibrierschaltung 2 über die Frequenz aufgetragen für eine Kurzschluss-Messung. Dargestellt ist in dieser Messung der S-Parameter der Eingangsreflexion $S_{11}$ z. B. des Anschlusstores $3_1$ für eine Kurzschluss-Messung. Dabei ist der Transistor $20_1$ im leitenden und der Transistor $21_1$ im sperrenden Zustand. Die weiteren Transistoren $20_2$ bis $20_4$ und $21_2$ bis $21_4$ befinden sich alle im leitenden Zustand. Zu erkennen ist, dass die rücklaufende Welle stärker gedämpft ist als die rücklaufende Welle in Fig. 6A. Dies liegt daran, dass der Transistor $20_1$ auch im voll leitenden Zustand einen Widerstand darstellt. Insgesamt ist der Signalverlauf aber sehr zufriedenstellend.

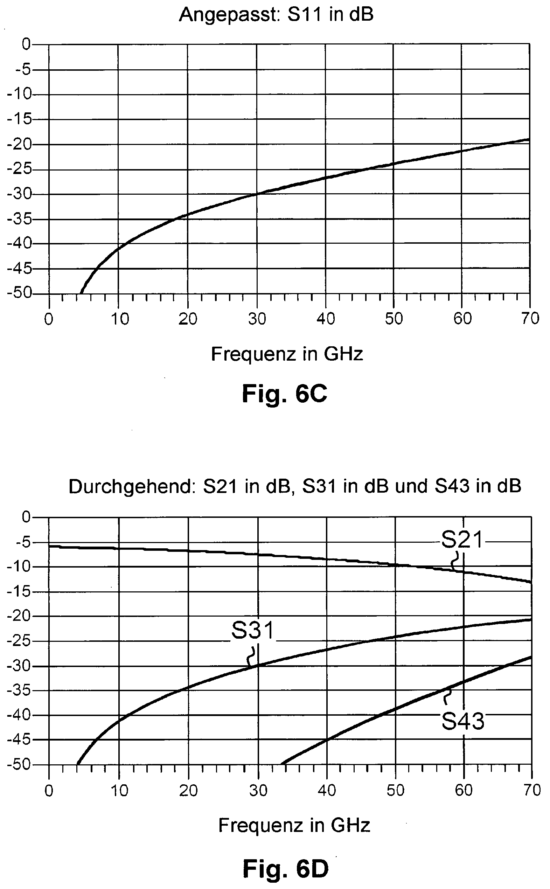

Fig. 6C zeigt ein Ausführungsbeispiel eines Amplitudengangs der erfindungsgemäßen Kalibrierschaltung 2 über die Frequenz aufgetragen für eine Angepasst-Messung. Dargestellt ist in dieser Messung der S-Parameter der Eingangsreflexion $S_{11}$ z. B. des Anschlusstores $3_1$ für die Kurzschluss-Messung. Dabei ist der Transistor $20_1$ als einstellbare Last derart betrieben, dass er bevorzugt einen Widerstand von 50 Ohm für den zu nutzenden Frequenzbereich aufweist. Hierzu muss, wie bereits erläutert, die Steuerspannung bzw. die Gatespannung entsprechend genau für die jeweilige Frequenz eingestellt werden. Der Transistor $21_1$ befindet sich im sperrenden Zustand. Die weiteren Transistoren $20_2$ bis $20_4$ und $21_2$ bis $21_4$ befinden sich alle im leitenden Zustand. Zu erkennen ist, dass die rücklaufende Welle für eine niedrige Frequenz in ihrer Amplitude sehr stark gedämpft ist, wobei die Amplitude für steigende Frequenzen weniger stark gedämpft ist. Bei einer Frequenz von 70 GHz weist die Amplitude einen Wert von ca. -19 dB auf.

Allerdings ist die Dämpfung auch bei 70 GHz ausreichend, weil eine Unterscheidbarkeit zwischen der Angepasst-Messung und der Offen-Messung sowie der Kurzschluss-Messung gewährleistet ist. Der Abstand der Dämpfung zwischen der Angepasst-Messung und der Kurzschluss-Messung beträgt immerhin 10 dB, so dass auch unter Einbeziehung des Koaxial-Koplanar-Mikrowellen-Übergangs zwischen den Anschlusstoren $3_1$ bis $3_4$ der Kalibrierschaltung 2 und den äußeren Toren $4_1$ bis $4_4$ der Kalibriereinrichtung 1 sowie der Kabelverbindung zwischen den äußeren Toren $4_1$ bis $4_4$ der Kalibriereinrichtung 1 und dem zu kalibrierenden Netzwerkanalysator noch eine ausreichende Unterscheidbarkeit zwischen den einzelnen Signalen gewährleistet ist.

Fig. 6D zeigt ein Ausführungsbeispiel eines Amplitudengangs der erfindungsgemäßen Kalibrierschaltung 2 über die Frequenz aufgetragen für eine Durchgehend-Messung. Die Anschlusstore $3_1$ und $3_2$ sind dabei über die Transistoren $21_1$ und $21_2$ verbunden, die beide in einem leitfähigen Zustand sind. Die Transistoren $20_1$ und $20_2$ sowie die Transistoren $21_3$ und $21_4$ sind in einem sperrenden Zustand. Um die Isolation zu erhöhen, sind die Transistoren $20_3$ und $20_4$ wiederum im leitenden Zustand.

Ein erster Signalverlauf S21 zeigt die Vorwärtstransmission $S_{21}$ vom Anschlusstor $3_1$ zum Anschlusstor $3_2$. Zu erkennen ist, dass der Signalverlauf S21 für hohe Frequenzen stärker gedämpft ist als für niedrige Frequenzen, weil sich bei hohen Frequenzen die parasitären Kapazitäten der Transistoren $20_1$ bis $20_4$ und $21_1$ bis $21_4$ stärker auswirken und weil die Transistoren $21_1$ und $21_2$ auch im leitenden Zustand bei höheren Frequenzen einen nicht zu vernachlässigen Widerstandswert beibehalten.

Ein zweiter Signalverlauf S31 zeigt den S-Parameter der Vorwärtstransmission $S_{31}$ vom Anschlusstor $3_1$ zum Anschlusstor $3_3$. Nach wie vor sind die Anschlusstore $3_1$ und $3_2$ über die leitenden Transistoren $21_1$ und $21_2$ miteinander verbunden. Die Transistoren $21_3$ und $21_4$ sind weiterhin im sperrenden Zustand. Dieser Signalverlauf S31 ist für niedrige Frequenzen sehr stark gedämpft und selbst bei Frequenzen von 70 GHz ist er noch ca. 8 dB stärker gedämpft als der Signalverlauf S21.

Ein dritter Signalverlauf S43 zeigt die Vorwärtstransmission S43 vom Anschlusstor $3_3$ zum Anschlusstor $3_4$. Nach wie vor sind die Anschlusstore $3_1$ und $3_2$ über die leitenden Transistoren $21_1$ und $21_2$ miteinander verbunden. Die Transistoren $21_3$ und $21_4$ sind weiterhin im sperrenden Zustand. Der Signalverlauf S43 ist erwartungsgemäß stärker gedämpft als die Signalverläufe S21 und S31.

Der zweite Signalverlauf 31 und der dritte Signalverlauf 43 spiegeln die parasitären Pfade wieder. Für den Fall, dass die zweiten Transistoren $21_1$ bis $21_n$ eine größere Gatebreite aufweisen würden, würde die Isolationsfähigkeit sinken und die Signalverläufe 31 und 43 wären weniger stark gedämpft.

Die Alterung der Kalibrierschaltung 2, speziell der Transistoren $20_1$, $20_2$ bis $20_n$ und $21_1$, $21_2$ bis $21_n$, wird dadurch vermindet, dass bei dem Kalibriervorgang nur Signale mit kleinen Leistungen angelegt werden. Ein Kalibrierintervall von zwei Jahren für die Kalibriereinrichtung 1 selbst, ist daher ausreichend.

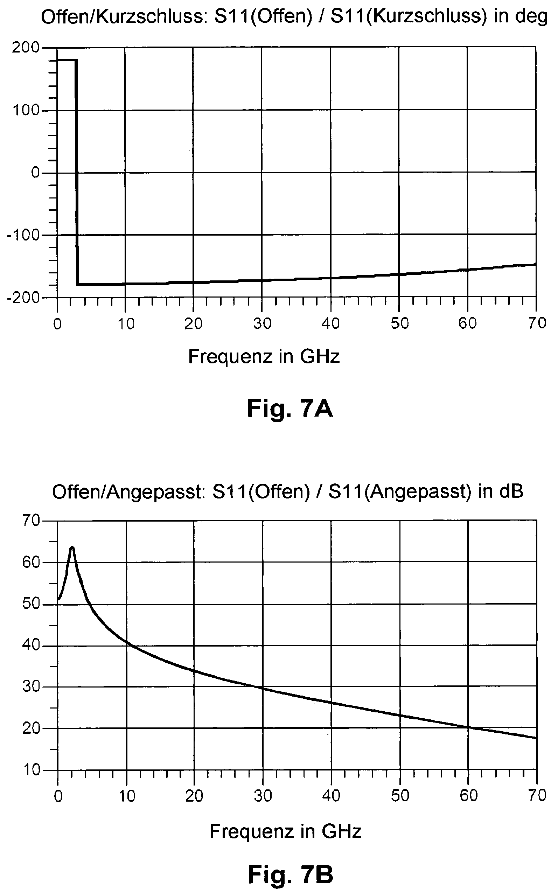

Fig. 7A zeigt ein Ausführungsbeispiel eines Verhältnisses zwischen einer Offen-Messung und einer Kurzschluss-Messung der erfindungsgemäßen Kalibrierschaltung 2 über die Frequenz aufgetragen. Wie bereits beschrieben ist die Unterscheidbarkeit zwischen der Offen-Messung und der Kurzschluss-Messung von essentieller Bedeutung, so dass es daher weniger stark darauf ankommt, wie frequenzunabhängig der Signalverlauf für eine Offen-Messung (Fig. 6A) oder Kurzschluss-Messung (Fig. 6B) ist. Als Kriterium zur Unterscheidung der Reflexionsstandards Offen und Kurzschluss dient dabei die Phase. Erkennbar ist, dass sich für niedrige Frequenzen ein Phasenversatz zwischen der Offen-Messung und der Kurzschluss-Messung von 180° einstellt. Selbst für höhere Frequenzen liegt der Phasenversatz deutlich näher bei 180° als bei 0°, so dass die erfindungsgemäße Kalibrierschaltung 2 eine sichere Unterscheidung der beiden Reflexionsstandards Offen und Kurzschluss erlaubt.

Fig. 7B zeigt ein Ausführungsbeispiel eines Verhältnisses zwischen einer Offen-Messung und einer Angepasst-Messung der erfindungsgemäßen Kalibrierschaltung 2 über die Frequenz aufgetragen. Wie bereits beschrieben ist außerdem die Unterscheidbarkeit zwischen der Offen-Messung und der Angepasst-Messung von großer Wichtigkeit, so dass es auch hier weniger darauf ankommt, wie frequenzunabhängig der Signalverlauf für eine Offen-Messung (Fig. 6A) oder Angepasst-Messung (Fig. 6C) ist. Als Kriterium zur Unterscheidung der Reflexionsstandards Offen und Angepasst dient dabei die Amplitude. Erkennbar ist, dass sich für niedrige Frequenzen für das Verhältnis der Reflexionsstandards Offen und Angepasst eine hohe Amplitude ergibt, was auf eine gute Unterscheidbarkeit zwischen beiden Reflexionsstandards hindeutet. Selbst für höhere Frequenzen ist die Amplitude des Verhältnisses der Reflexionsstandards Offen und Angepasst mit ca. 18 dB deutlich größer als 0 dB, so dass zwischen den Reflexionsstandards Offen und Angepasst sicher unterschieden werden kann.

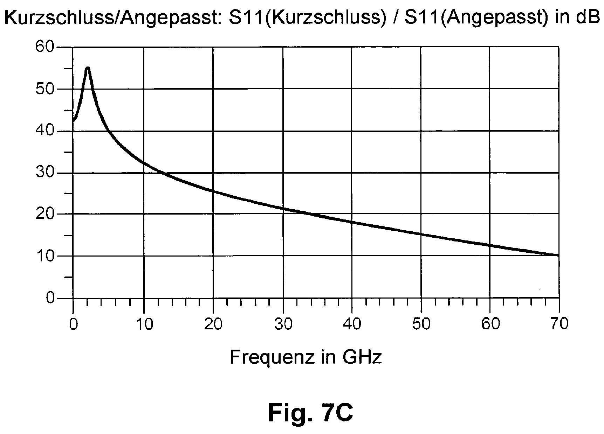

Fig. 7C zeigt ein Ausführungsbeispiel eines Verhältnisses zwischen einer Kurzschluss-Messung und einer Offen-Messung der erfindungsgemäßen Kalibrierschaltung 2 über die Frequenz aufgetragen. Wie bereits erläutert ist auch die Unterscheidbarkeit zwischen der Kurzschluss-Messung und der Angepasst-Messung von großer Bedeutung, so dass es daher weniger darauf ankommt, wie frequenzunabhängig der Signalverlauf für eine Kurschluss-Messung (Fig. 6B) oder für eine Angepasst-Messung (Fig. 6C) letztlich ist. Als Kriterium zur Unterscheidung der Reflexionsstandards Kurzschluss und Angepasst dient dabei die Amplitude. Erkennbar ist, dass sich für niedrige Frequenzen für das Verhältnis der Reflexionsstandards Kurzschluss und Angepasst eine hohe Amplitude ergibt, was auf eine gute Unterscheidbarkeit zwischen beiden Reflexionsstandards hindeutet. Aber selbst für höhere Frequenzen ist die Amplitude des Verhältnisses der Reflexionsstandards Kurzschluss und Angepasst mit ca. 10 dB deutlich größer als 0 dB, so dass zwischen den Reflexionsstandards Offen und Angepasst sicher unterschieden werden kann.

Würde die Gatebreite der zweiten Transistoren $21_1$, $21_2$ bis $21_n$ auf die Gatebreite der ersten Transistoren $20_1$, $20_2$ bis $20_n$ vergrößert werden, würden die parasitären Kapazitäten derart ansteigen, dass eine sichere Unterscheidung der Reflexionsstandards Kurzschluss und Angepasst nicht mehr sicher möglich wäre.

Es ist weiterhin möglich, dass für die als einstellbare Last betriebenen ersten Transistoren $20_1$ bis $20_n$ der Kalibriereinrichtung 1 ein beliebiger Wert, wie z.B. 100 Ohm oder 200 Ohm einstellbar ist, um die Genauigkeit der Kalibrierung zu erhöhen und/oder um die Güte der Kalibrierung festzustellen. Ebenfalls ermöglicht das Einstellen beliebiger resistiver Zwischenzustände an den ersten Transistoren $20_1$ bis $20_n$, dass Messobjekte, die einen von 50 Ohm abweichenden Wellenwiderstand aufweisen, genauer vermessen werden können.

Die Kalibriereinrichtung 1 kann auch zum Kalibrieren von beliebigen anderen Messgeräten als einem Netzwerkanalysator verwendet werden, solange diese das Aufschalten von genau bekannten Lasten an ihren Anschlusstoren erfordern.

**Patentansprüche**

1.  Kalibriereinrichtung (1) für einen Netzwerkanalysator mit mehrere Toren, aufweisend eine Kalibrierschaltung (2), die über je ein Anschlusstor ($3_1$ bis $3_n$) mit je einem der mehreren Tore des Netzwerkanalysators verbunden ist, wobei an jedem Anschlusstor ($3_1$ bis $3_n$) je ein erster Transistor ($20_1$ bis $20_n$) und je ein zweiter Transistor ($21_1$ bis $21_n$) in Reihe geschaltet sind, wobei beide Transistoren ($20_1$ bis $20_n$ und $21_1$ bis $21_n$) an ihrer gemeinsamen Verbindung ($24_1$ bis $24_n$) mit dem Anschlusstor ($3_1$ bis $3_n$) verbunden sind, wobei für jedes der mehreren Tore des Netzwerkanalysators genau ein erster Transistor ($20_1$ bis $20_n$) und genau ein zweiter Transistor ($21_1$ bis $21_n$) innerhalb der Kalibrierschaltung (2) vorhanden sind, wobei die ersten Transistoren ($20_1$ bis $20_n$) als einstellbare Lasten betrieben sind, wobei die einstellbaren Lasten der ersten Transistoren ($20_1$ bis $20_n$) durch Anlegen einer Gatespannung oder eines Basisstroms an diese mittels einer Spannungs- bzw. Stromquelle der Kalibrier einrichtung einstellbar sind, wobei die Spannungs-bzw. Stromquelle der art eingestellt ist, dass es sich bei einer der einstellbaren Lasten um einen resistiren Zwischenzustand handelt, wobei der jeweilige Transistor ($20_1$ bis $20_n$) dabei nicht in die Sättigung getrieben ist, wodurch auf einen separaten Abschlusswiderstand verzichtet werden kann.

2.  Kalibriereinrichtung nach Anspruch 1,
    **dadurch gekennzeichnet,**
    **dass** der resistive Zwischenzustand dabei zwischen einem niederohmigen leitenden Zustand und einem hochohmigen
    sperrenden Zustand liegt.

3.  Kalibriereinrichtung nach Anspruch 1 oder 2,
    **dadurch gekennzeichnet,**
    **dass** beim Einstellen der Gatespannung oder des Basisstroms temperaturabhängige Eigenschaften der Transistoren ($20_1$ bis $20_n$) kompensiert sind.

4.  Kalibriereinrichtung nach Anspruch 3,
    **dadurch gekennzeichnet,**
    **dass** die Kalibriereinrichtung (1) eine Speichereinheit (8) aufweist und
    **dass** die Speichereinheit (8) Korrekturdaten enthält, die das temperaturabhängige Verhalten zumindest eines der Transistoren ($20_1$ bis $20_n$) berücksichtigen.

5.  Kalibriereinrichtung nach einem der vorherigen Ansprüche,
    **dadurch gekennzeichnet,**
    **dass** die Kalibriereinrichtung (1) eine thermostatische Regelung (7) enthält, wodurch die Kalibrierschaltung (2) auf eine konstante Temperatur beheizbar ist.

6.  Kalibriereinrichtung nach einem der vorherigen Ansprüche,
    **dadurch gekennzeichnet,**
    **dass** ein erster Anschluss jedes ersten Transistors ($20_1$ bis $20_n$) mit einer Bezugsmasse (26) verbunden ist.

7.  Kalibriereinrichtung nach einem der vorherigen Ansprüche,
    **dadurch gekennzeichnet,**
    **dass** jeder erste Transistor ($20_1$ bis $20_n$) und jeder zweite Transistor ($21_1$ bis $21_n$) ein Transistorpaar ($27_1$ bis $27_n$) bilden und
    **dass** mehrere solcher Transistorpaare ($27_1$ bis $27_n$) über einen nicht mit der gemeinsamen Verbindung ($24_1$ bis $24_n$) verbundenen Anschluss des jeweiligen zweiten Transistoren ($21_1$ bis $21_n$) miteinander verbindbar sind.

8.  Kalibriereinrichtung nach einem der vorherigen Ansprüche,
    **dadurch gekennzeichnet,**
    **dass** sich die Kalibrierschaltung (2) in einer integrierten Schaltung befindet, die bevorzugt durch einen MMIC-Prozess hergestellt ist.

9.  Kalibriereinrichtung nach einem der vorherigen Ansprüche,
    **dadurch gekennzeichnet,**
    **dass** die mehreren Anschlusstore ($3_1$ bis $3_n$) der Kalibrierschaltung (2) mit mehreren äußeren Toren ($4_1$ bis $4_n$) der Kalibriereinrichtung (1) über einen Koaxial-Koplanar-Mikrowellen-Übergang verbunden sind.

**10.** Kalibriereinrichtung nach einem der vorherigen Ansprüche,
**dadurch gekennzeichnet,**
**dass** für jedes Tor des Netzwerkanalysators die Lastzustände wie Offen, Kurzschluss und Angepasst durch jeweils den ersten Transistor ($20_1$ bis $20_n$) und/oder jeweils den zweiten Transistor ($21_1$ bis $21_n$) einstellbar sind.

**11.** Kalibriereinrichtung nach Anspruch 10,
**dadurch gekennzeichnet,**
**dass** die einstellbare Last des ersten Transistors ($20_1$ bis $20_n$) zumindest nahezu einer Systemimpedanz des zu kalibrierenden Netzwerkanalysators entspricht.

**12.** Kalibriereinrichtung nach Anspruch 10 oder 11,
**dadurch gekennzeichnet,**
**dass** die Lastzustände Offen, Kurzschluss und Angepasst für alle der mehreren Tore des Netzwerkanalysators parallel einstellbar und/oder messbar sind.

**13.** Kalibriereinrichtung nach einem der vorherigen Ansprüche,
**dadurch gekennzeichnet,**
**dass** es sich bei den Transistoren ($20_1$ bis $20_n$ und $21_1$ bis $21_n$) um Feldeffekttransistoren handelt und
**dass** eine Gatebreite jedes ersten Transistors ($20_1$ bis $20_n$) größer ist, als eine Gatebreite jedes zweiten Transistors ($21_1$ bis $21_n$).

**Claims**

**1.** Calibrating device (1) for a network analyser with a plurality of ports, exhibiting a calibrating circuit (2) which is connected by means of in each case a connecting port ($3_1$ to $3_n$) with in each case one of the plurality of ports of the network analyser, wherein in each case a first transistor ($20_1$ to $20_n$) and in each case a second transistor ($21_1$ to $21_n$) are connected in series to each connecting port ($3_1$ to 3n), wherein both transistors ($20_1$ to $20_n$ and $21_1$ to $21_n$) are connected at their common connection ($24_1$ to 24n) with the connecting port ($3_1$ to $3_n$),
wherein just one first transistor ($20_1$ to $20_n$) and just one second transistor ($21_1$ to $21_n$) within the calibrating circuit (2) are available for each of the plurality of ports of the network analyser,
wherein the first transistors ($20_1$ to $20_n$) are operated as adjustable loads,
wherein the adjustable loads of the first transistors ($20_1$ to $20_n$) are adjustable by applying a gate voltage or a base current to the latter by means of a voltage source or current source of the calibrating device,
wherein the voltage source or current source is adjusted in such a way that one of the adjustable loads is a resistive intermediate state,
wherein the respective transistor ($20_1$ to $20_n$) is not driven to saturation point so that a separate terminating resistor can be omitted.

**2.** Calibrating device according to claim 1,
**characterised in that**
the resistive intermediate state lies between a low-ohmic conducting state and a high-ohmic blocking state.

**3.** Calibrating device according to claim 1 or 2,
**characterised in that**
temperature-dependent properties/characteristics of the transistors ($20_1$ to $20_n$) are compensated when the gate voltage or base current is set.

**4.** Calibrating device according to claim 3,
**characterised in that**
the calibrating device (1) exhibits a memory unit (8) and
**in that** the memory unit (8) contains correction data which take account of the temperature-dependent behaviour of at least one of the transistors ($20_1$ to $20_n$).

**5.** Calibrating device according to one of the preceding claims,
**characterised in that**
the calibrating device (1) comprises a thermostatic control (7) through which the calibrating circuit (2) can be heated to a constant temperature.

**6.** Calibrating device according to one of the preceding claims,
**characterised in that**
a first connection of each first transistor ($20_1$ to $20_n$) is connected with a reference ground (26).

**7.** Calibrating device according to one of the preceding claims,
**characterised in that**
each first transistor ($20_1$ to $20_n$) and each second transistor ($21_1$ to $21_n$) form a transistor pair ($27_1$ to $27_n$) and **in that** a plurality of such transistor pairs ($27_1$ to $27_n$) can be connected with one another by means of a connection of the respective second transistor ($21_1$ to $21_n$) not connected with the common connection ($24_1$ to $24_n$).

**8.** Calibrating device according to one of the preceding claims,
**characterised in that**
the calibrating circuit (2) is located in an integrated circuit which is preferably produced by an MMIC process.

**9.** Calibrating device according to one of the preceding claims,
**characterised in that**
the plurality of connecting ports ($3_1$ to $3_n$) of the calibrating circuit (2) can be connected with a plurality of external ports ($4_1$ to $4_n$) of the calibrating device (1) by means of a coaxial coplanar microwave junction.

**10.** Calibrating device according to one of the preceding claims,
**characterised in that**
for each port of the network analyser the load states such as Open, Short and Match can be set by in each case the first transistor ($20_1$ to $20_n$) and/or in each case the second transistor ($21_1$ to $21_n$).

**11.** Calibrating device according to claim 10,
**characterised in that**
the adjustable load of the first transistor ($20_1$ to $20_n$) corresponds at least approximately to a system impedance of the network analyser to be calibrated.

**12.** Calibrating device according to claim 10 or 11,
**characterised in that**
the load states Open, Short and Match for all of the plurality of ports of the network analyser can be adjusted and/or measured in parallel.

**13.** Calibrating device according to one of the preceding claims,
**characterised in that**
the transistors ($20_1$ to $20_n$ and $21_1$ to $21_n$) are field-effect transistors and **in that** a gate width of each first transistor ($20_1$ to $20_n$) is greater than a gate width of each second transistor ($21_1$ to $21_n$).

**Revendications**

**1.** Système d'étalonnage (1) pour un analyseur de réseau comportant plusieurs accès, comprenant un circuit d'étalonnage (2), qui est relié par l'intermédiaire d'un point de connexion ($3_1$ à $3_n$) à l'une de la pluralité d'accès de l'analyseur de réseau,
dans lequel un premier transistor ($20_1$ à $20_n$) et un second transistor ($21_1$ à $21_n$) sont montés en série à chaque accès de connexion ($3_1$ à $3_n$),
dans lequel les deux transistors ($20_1$ à $20_n$ et $21_1$ à $21_n$) sont reliés à un point de connexion ($3_1$ à $3_n$) à leur liaison commune ($24_1$ à $24_n$),
dans lequel pour chacun de la pluralité d'accès de l'analyseur de réseau, il existe précisément un premier transistor ($20_1$ à $20_n$) et précisément un second transistor ($21_1$ à $21_n$) dans le circuit d'étalonnage (2), dans lequel les premiers transistors ($20_1$ à $20_n$) sont actionnés en tant que charges réglables,
dans lequel les charges réglables des premiers transistors ($20_1$ à $20_n$) sont réglables grâce à une source de tension ou de courant du système d'étalonnage lors de l'application d'une tension de grille ou d'un courant de base à celles-ci, dans lequel la source de tension ou de courant est réglée de sorte que, en ce qui concerne une des charges réglables, il s'agit d'un état intermédiaire résistif, dans lequel le transistor respectif ($20_1$ à $20_n$) ne fonctionne pas à saturation, moyennant quoi on peut se passer d'une résistance terminale distincte.

**2.** Système étalonnage selon la revendication 1, **caractérisé en ce que**
l'état intermédiaire résistif se trouve ainsi entre un état conducteur faiblement ohmique et un état bloquant hautement ohmique.

**3.** Système d'étalonnage selon la revendication 1 ou 2, **caractérisé en ce que**
lors du réglage de la tension de grille ou du courant de base, des propriétés dépendantes de la température des transistors ($20_1$ à $20_n$) sont compensées.

**4.** Système d'étalonnage selon la revendication 3, **caractérisé en ce que**
le système d'étalonnage (1) présente une unité de mémoire (8) et
**en ce que** l'unité de mémoire (8) comporte des données de correction, qui prennent en considération le comportement dépendant de la température d'au moins un des transistors ($20_1$ à $20_n$).

**5.** Système d'étalonnage selon l'une des revendications précédentes, **caractérisé en ce que**
le système d'étalonnage (1) comporte une régulation thermostatique (7), grâce à laquelle le circuit d'étalonnage (2) peut être chauffé à une température constante.

**6.** Système d'étalonnage selon l'une des revendications précédentes, **caractérisé en ce que**
une première liaison de chaque premier transistor ($20_1$ à $20_n$) est reliée à une masse de référence (26).

**7.** Système d'étalonnage selon l'une des revendications précédentes, **caractérisé en ce que**
chaque premier transistor ($20_1$ à $20_n$) et chaque second transistor ($21_1$ à $21_n$) forment une paire de transistors ($27_1$ à $27_n$) et
**en ce que** plusieurs de ces paires de transistors ($27_1$ à $27_n$) peuvent être reliées les unes aux autres par l'intermédiaire d'une liaison reliée à une liaison commune ($24_1$ à $24_n$) du second transistor respectif ($21_1$ à $21_n$).

**8.** Système d'étalonnage selon l'une des revendications précédentes, **caractérisé en ce que**
le circuit d'étalonnage (2) se trouve dans un circuit intégré, qui est fabriqué de préférence par un processus MMIC.

**9.** Système d'étalonnage selon l'une des revendications précédentes, **caractérisé en ce que**
la pluralité de points de connexion ($3_1$ à $3_n$) du circuit de calibrage (2) sont reliés à une pluralité d'accès extérieurs ($4_1$ à $4_n$) du système d'étalonnage (1) par l'intermédiaire d'une jonction hyperfréquence coplanaire coaxiale.

**10.** Système d'étalonnage selon l'une des revendications précédentes, **caractérisé en ce que**
pour chaque accès de l'analyseur de réseau, les états de charge comme ouvert, court-circuit et complet peuvent être réglés par le premier transistor respectif ($20_1$ à $20_n$) et/ou le second transistor respectif ($21_1$ à $21_n$).

**11.** Système d'étalonnage selon la revendication 10, **caractérisé en ce que**
la charge réglable du premier transistor ($20_1$ à $20_n$) correspond au moins presque à une impédance du système de l'analyseur de réseau à étalonner.

**12.** Système de calibrage selon la revendication 10 ou 11, **caractérisé en ce que**
les états de charge ouvert, court-circuit et complet peuvent être mesurés et/ou réglés en parallèle pour l'ensemble de la pluralité d'accès de l'analyseur de réseau.

**13.** Système d'étalonnage selon l'une des revendications précédentes, **caractérisé en ce que**
concernant les transistors ($20_1$ à $20_n$ et $21_1$ à $21_n$), il s'agit de transistors à effet de champ et
**en ce qu'**une largeur de grille de chaque premier transistor ($20_1$ à $20_n$) est plus grande qu'une largeur de grille de chaque second transistor ($21_1$ à $21_n$).

**Fig. 1**

**Fig. 2**

**Fig. 3**

**Fig. 4**

**Fig. 5**

Offen: S11 in dB

Frequenz in GHz

**Fig. 6A**

Kurzschluss: S11 in dB

Frequenz in GHz

**Fig. 6B**

Angepasst: S11 in dB

Frequenz in GHz

**Fig. 6C**

Durchgehend: S21 in dB, S31 in dB und S43 in dB

Frequenz in GHz

**Fig. 6D**

Offen/Kurzschluss: S11(Offen) / S11(Kurzschluss) in deg

Frequenz in GHz

**Fig. 7A**

Offen/Angepasst: S11(Offen) / S11(Angepasst) in dB

Frequenz in GHz

**Fig. 7B**

Kurzschluss/Angepasst: S11(Kurzschluss) / S11(Angepasst) in dB

Frequenz in GHz

**Fig. 7C**

**EP 2 609 435 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6914436 B2
- US 20080197858 A
- DE 102007013968 A1